Europäisches Patentamt

European Patent Office

Office européen des brevets

(19)

(11) Veröffentlichungsnummer: **0 271 058**
**B1**

(12) **EUROPÄISCHE PATENTSCHRIFT**

(45) Veröffentlichungstag der Patentschrift:
**03.10.90**

(51) Int. Cl.⁵: **H03J 5/02**

(21) Anmeldenummer: **87118143.4**

(22) Anmeldetag: **08.12.87**

(54) **Einrichtung zur Programmierung von Empfangsgeräten.**

(30) Priorität: **11.12.86 DE 3642365**

(43) Veröffentlichungstag der Anmeldung:
**15.06.88 Patentblatt 88/24**

(45) Bekanntmachung des Hinweises auf die Patenterteilung:
**03.10.90 Patentblatt 90/40**

(84) Benannte Vertragsstaaten:
**AT CH FR GB IT LI**

(56) Entgegenhaltungen:
**EP-A- 0 309 878**
**DE-A- 2 625 131**
**DE-A- 3 640 437**
**DE-U- 8 717 283**
**US-A- 4 525 865**

(73) Patentinhaber: **GRUNDIG E.M.V. Elektro-Mechanische Versuchsanstalt Max Grundig holländ. Stiftung & Co. KG., Kurgartenstrasse 37, D-8510 Fürth/Bay.(DE)**

(72) Erfinder: **Boller, Peter c/o GRUNDIG E.M.V., Max Grundig holländ Stiftung & Co KG, Kurgartenstrasse 37 D-8510 Fürth/Bay.(DE)**

## Beschreibung

Die Erfindung betrifft eine Einrichtung zur Programmierung von mit Abstimmdatenspeichern ausgestatteten Empfangsgeräten.

Bei bekannten Empfangsgeräten der Unterhaltungselektronik erfolgt die Eingabe und Abspeicherung der Abstimmdaten der jeweils empfangbaren Sender mit Hilfe eines am Gerät befindlichen oder vom Gerät abgesetzten, manuell betätigbaren Bedienteils. Mit zunehmendem Programmangebot, insbesondere auch über Kabel und Satellit, wird aber die Programmierung für den Fachhändler oder den Kunden, der das Gerät verkaufen bzw. betreiben soll, immer aufwendiger und zeitintensiver.

Die Patentschriften US-A 4 525 865 und DE-A-2 625 131 beschreiben Systeme zum Programmieren von TV- bzw Radioempfängern, befassen sich jedoch nicht mit der Möglichkeit, Abstimmdaten, die einem nichtflüchtigen Abstimmdatenspeicher entnommen werden können, in auswählbaren, bestimmten Empfangsbereichen entsprechenden Blöcken in die Abstimmdatenspeicher der Empfangsgeräte zu übertragen.

Der Erfindung liegt die Aufgabe zugrunde, eine Einrichtung der im Oberbegriff des Anspruchs 1 angegebenen Art so auszubilden, dass Programmierung des Empfängers vereinfacht wird und weniger Zeit in Anspruch nimmt.

Diese Aufgabe wird gemäß der Erfindung durch die im Kennzeichen des Patentanspruchs 1 angegebenen Merkmale gelöst.

Bei der Einrichtung gemäß der Erfindung ist in vorteilhafter Weise ein eigener nichtflüchtiger Abstimmdatenspeicher vorgesehen, von dem aus einmal abgespeicherte Abstimmdaten leitungslos oder leitungsgebunden in die jeweiligen Abstimmdatenspeicher der zu programmierenden Empfangsgeräte übertragbar sind. Der Zeitaufwand zur Programmierung eines Gerätes verringert sich hierdurch auf einen Bruchteil der sonst üblichen manuellen Programmierzeit.

Bei der Einrichtung gemäß der Erfindung sind die dem nichtflüchtigen Abstimmdatenspeicher entnehmbaren Abstimmdaten in auswählbaren Blöcken in die Abstimmdatenspeicher der Empfangsgeräte übertragbar. Die betreffenden Datenblöcke enthalten hierbei die Daten der Sender, die an jeweils unterschiedlichen Standorten der Empfangsgeräte empfangbar sind. Es wird hiermit auf sehr einfache Weise die Möglichkeit geschaffen, einen Empfänger in sehr kurzer Zeit kundenspezifisch, das heißt in Abhängigkeit vom Wohnort des Kunden, zu programmieren.

Die manuelle Programmierarbeit zum Beispiel eines Fachhändlers beschränkt sich somit lediglich auf die einmalige Programmierung der Einrichtung gemäß der Erfindung. Die hier einmal abgespeicherten Abstimmdaten können dann in auswählbaren Blöcken in die Abstimmdatenspeicher einer beliebigen Anzahl von Empfangsgeräten übertragen werden.

## Patentansprüche

Einrichtung zur Programmierung von mit Abstimmdatenspeichern ausgestatteten Empfangsgeräten, mit einem nichtflüchtigen eigenen Abstimmdatenspeicher, von dem aus einmal abgespeicherte Abstimmdaten leitungslos oder leitungsgebunden in die jeweiligen Abstimmdatenspeicher der Empfangsgeräte übertragbar sind, dadurch gekennzeichnet, daß die dem nichtflüchtigen Abstimmdatenspeicher entnehmbaren Abstimmdaten in auswählbaren Blöcken, die die Daten der Sender enthalten, die an jeweils unterschiedlichen Standorten der Empfangsgeräte empfangbar sind, in die Abstimmdatenspeicher der Empfangsgeräte übertragbar sind.

## Claims

1. Device for programming receiving devices equipped with tuning data memories, having its own non-volatile tuning data memory, from where already stored tuning data can be transmitted with or without using wiring into the respective tuning data memories of the receiving devices, characterized in that the tuning data, which can be taken from the non-volatile tuning data memory, can be transmitted into the tuning data memories of the receiving devices in selectable blocks containing the data of the stations which can be received at respective various locations of the receiving devices.

## Revendications

Dispositif pour programmer des appareils récepteurs équipés de mémoires de données de syntonisation, et comportant une mémoire propre non volatile de données de syntonisation, à partir de laquelle des données de syntonisation mémorisées peuvent être retransmises sans fil ou bien à l'aide d'un conducteur aux mémoires respectives de données de syntonisation des appareils récepteurs, caractérisé en ce que les données de syntonisation pouvant être prélevées de la mémoire non volatile de données de syntonisation peuvent être transférées, sous la forme de blocs pouvant être sélectionnés, qui contiennent les données des émetteurs qui peuvent être reçus au niveau des différents emplacements respectifs des appareils récepteurs, dans les mémoires de données de syntonisation des appareils récepteurs.